# EUROPEAN PATENT APPLICATION

(11) **EP 4 621 394 A1**
(43) Date of publication of application: **24.09.2025**
(21) Application number: 23917451.9
(22) Date of filing: 17.01.2023
(51) Int. Cl.: G01N 23/00

(54) **RADIATION BEAM SCANNING OPTICAL SYSTEM AND INSPECTION APPARATUS**

(71) Applicant: Hamamatsu Photonics K.K., Hamamatsu-shi, Shizuoka 435-8558 (JP)
(72) Inventor: UCHIKADO, Akihito, Hamamatsu-shi, Shizuoka 435-8558 (JP); NAKAMURA, Tomonori, Hamamatsu-shi, Shizuoka 435-8558 (JP); OKADA, Tomoyuki, Hamamatsu-shi, Shizuoka 435-8558 (JP); MATSUMOTO, Toru, Hamamatsu-shi, Shizuoka 435-8558 (JP); IKESU, Masataka, Hamamatsu-shi, Shizuoka 435-8558 (JP)
(74) Representative: Hoffmann Eitle
(86) International application number: PCT/JP2023/001232
(87) International publication number: WO 2024/154237

(57) **Abstract**

An X-ray beam scanning optical system 10 includes an X-ray source 11 that outputs an X-ray beam R1 toward a semiconductor device 100, a first capillary lens 12 that renders the X-ray beam R1 output from the X-ray source 11 into an X-ray beam R2 that is parallel X-rays, a second capillary lens 13 that condenses the X-ray beam R2 having passed through the first capillary lens 12 on the semiconductor device 100, and a shielding member 14 disposed between the X-ray source 11 and the semiconductor device 100. Further, the inspection apparatus 1 includes a drive unit (here, shielding member 14) that moves the second capillary lens 13, and the drive control unit 15 that controls the shielding member 14 so as to move the second capillary lens 13 such that the X-ray beam condensed on the semiconductor device 100 is scanned while a state where the optical axis at the emission end 12b of the first capillary lens 12 and the optical axis at the incident end 13a of the second capillary lens 13 are parallel is maintained.

## Description

### Technical Field

An aspect of the present invention relates to a radiation beam scanning optical system and an inspection apparatus.

### Background Art

A semiconductor inspection apparatus that inspects a defective portion of a semiconductor device is known (see, for example, Patent Literature 1). The semiconductor inspection apparatus described in Patent Literature 1 emits an X-ray beam instead of a light beam in a method called an optical beam induced resistive change (OBIRCH). In such a semiconductor inspection apparatus, the semiconductor device is irradiated with the X-ray beam, a temperature at a specific position of the semiconductor device changes due to heat, and a resistance change accompanying the change is observed. Accordingly, the defective portion of the semiconductor device is specified.

### Citation List

### Patent Literature

Patent Literature 1: Japanese Unexamined Patent Publication No. 2001-160573

### Summary of Invention

### Technical Problem

In recent years, as a degree of integration of the semiconductor device increases, a wiring layer becomes thicker, and it is difficult to stimulate an inside of a chip for failure analysis. In this regard, as in Patent Literature 1 described above, X-rays are used as a heat source, and thus, it is possible to stimulate a deep portion of the semiconductor device to which light does not reach and to specify the defective portion with high accuracy.

Here, the X-ray source is generally heavy, and it is difficult to finely move the X-ray source at a high speed. Thus, when the X-ray beam is scanned, it is conceivable to move the semiconductor device side which is an object on which the X-ray beam is condensed. However, in recent years, the number of terminals of the semiconductor device is enormous, and it may be difficult to scan the X-ray beam by moving the semiconductor device in consideration of these wirings and the like.

An aspect of the present invention has been made in view of the above circumstances, and an object thereof is to provide a radiation beam scanning optical system and an inspection apparatus capable of scanning a radiation beam without moving a radiation source and an object on which the radiation beam is condensed.

### Solution to Problem

A radiation beam scanning optical system according to an aspect of the present invention includes a radiation source configured to output a radiation beam toward an object, a first capillary lens configured to render the radiation beam output from the radiation source into parallel light, a second capillary lens configured to condense the radiation beam having passed through the first capillary lens on the object, a shielding member disposed between the radiation source and the object, a drive unit configured to move the second capillary lens, and a control unit configured to control the drive unit to move the second capillary lens such that the radiation beam condensed on the object is scanned while a state where an optical axis at an emission end of the first capillary lens and an optical axis at an incident end of the second capillary lens are parallel is maintained.

In the radiation scanning beam optical system according to the aspect of the present invention, the radiation beam rendered into the parallel light by the first capillary lens is condensed on the object by the second capillary lens. As described above, the light is once rendered into the parallel light and then condensed on the object by the second capillary lens. As a result, condensing accuracy can be enhanced. Then, in the radiation beam scanning optical system, the second capillary lens is moved in a state where a parallel relationship between the optical axes of the first capillary lens and the second capillary lens is maintained, and thus, the radiation beam is scanned in the object. As described above, when the second capillary lens moves, the parallel relationship between the optical axes of the first capillary lens and the second capillary lens is maintained, and thus, the radiation beam can be scanned while the condensing accuracy is maintained. As described above, according to the radiation beam scanning optical system of the aspect of the present invention, the radiation beam can be appropriately scanned with respect to the object by moving the second capillary lens without moving the radiation source and the object.

The first capillary lens and the second capillary lens may have a substantially columnar shape, and a lens diameter at an incident end of the second capillary lens may be smaller than a lens diameter at an emission end of the first capillary lens. According to such a configuration, a range in which the radiation beam is emitted from the first capillary lens can be widened, and a range in which the radiation beam can be scanned by the movement of the second capillary lens can be widened. As a result, the radiation beam can be more appropriately scanned with respect to the object.

The first capillary lens and the second capillary lens may have a substantially columnar shape, and a lens diameter at the incident end of the second capillary lens may be larger than a lens diameter at the emission end of the first capillary lens. According to such a configuration, it is possible to increase utilization efficiency of the radiation beam emitted from the first capillary lens and scan the object with the radiation beam.

The shielding member may be disposed between the radiation source and an emission end of the second capillary lens. According to such a configuration, an unnecessary radiation beam can be appropriately shielded.

The shielding member may have a downstream shielding unit provided in the second capillary lens. According to such a configuration, it is possible to appropriately shield the radiation beam emitted from the first capillary lens and not incident on the second capillary lens.

The downstream shielding unit may be provided so as to cover a side surface of the second capillary lens. According to such a configuration, the radiation beam can be appropriately shielded on the side surface of the second capillary lens.

The downstream shielding unit may function as the drive unit. According to such a configuration, the shielding unit can also be used as the drive unit, and the apparatus configuration can be simplified.

The shielding member may have an upstream shielding unit provided in the first capillary lens. According to such a configuration, it is possible to appropriately shield the radiation beam output from the radiation source and not incident on the first capillary lens.

The upstream shielding unit may be provided so as to surround the radiation source. According to such a configuration, it is possible to more reliably shield the radiation beam output from the radiation source and not incident on the first capillary lens.

The shielding member may include a downstream shielding unit provided in the second capillary lens and an upstream shielding unit provided in the first capillary lens. According to such a configuration, both the radiation beam output from the radiation source and the radiation beam emitted from the first capillary lens can be appropriately shielded.

The control unit may control the drive unit to move the second capillary lens within a range in which a light amount of the radiation beam incident on the incident end of the second capillary lens is constant. According to such a configuration, it is possible to suppress variation in the light amount of the radiation beam at the time of scanning and to more appropriately scan the object with the radiation beam.

The radiation beam scanning optical system may include a plurality of sets of condensing sets each including one radiation source, one first capillary lens, and one second capillary lens. In order to stimulate one point in the object with the radiation beam, the radiation beam is preferably irradiated from a plurality of directions. In this regard, as described above, the plurality of condensing sets are provided, and the radiation beam can be emitted from the plurality of directions. As a result, one point in the object can be effectively stimulated.

An inspection apparatus according to another aspect of the present invention is an inspection apparatus that inspects a semiconductor device to which a test signal is input. The inspection apparatus includes the radiation beam scanning optical system in which the semiconductor device is scanned with a radiation beam with the semiconductor device as the object, and an analysis unit configured to inspect the semiconductor device based on an electric signal output from the semiconductor device scanned with the radiation beam. According to such an inspection apparatus, the above-described radiation beam scanning optical system can appropriately scan the semiconductor device with the radiation beam without moving the radiation source and the semiconductor device, and inspect the semiconductor device with high accuracy.

### Advantageous Effects of Invention

According to the aspect of the present invention, it is possible to provide the radiation beam scanning optical system and the inspection apparatus capable of scanning radiation without moving the radiation source and the object on which radiation is condensed.

### Brief Description of Drawings

FIG. 1 is a diagram schematically illustrating an inspection apparatus according to a first embodiment of the present invention.
FIG. 2 is a side view illustrating a first capillary lens.
FIG. 3 is a side view illustrating a second capillary lens.
FIG. 4 is a diagram for explaining movement of the second capillary lens.
FIG. 5(a) is a diagram for explaining an irradiation range of an X-ray beam in a case where the second capillary lens is positioned at a center position, and FIG. 5(b) is a diagram for describing the irradiation range of the X-ray beam in a case where the second capillary lens is positioned at an end position.
FIG. 6 is a diagram schematically illustrating an X-ray beam scanning optical system according to a second embodiment of the present invention.
FIG. 7 is a diagram schematically illustrating an X-ray beam scanning optical system according to a third embodiment of the present invention.
FIG. 8(a) is a diagram for explaining the irradiation range of the X-ray beam in a case where the second capillary lens is positioned at the center position, and FIG. 8(b) is a diagram for explaining the irradiation range of the X-ray beam in a case where the second capillary lens is positioned at the end position.
FIG. 9(a) is a diagram for explaining a path of the X-ray beam in a case where the second capillary lens is positioned at the center position, and FIG. 9(b) is a diagram for explaining the path of the X-ray beam in a case where the second capillary lens is positioned at the end position.
FIG. 10 is a diagram schematically illustrating an X-ray beam scanning optical system according to a fourth embodiment of the present invention.
FIG. 11 is a diagram schematically illustrating an X-ray beam scanning optical system according to a fifth embodiment of the present invention.
FIG. 12 is a diagram schematically illustrating an X-ray beam scanning optical system according to a sixth embodiment of the present invention.
FIG. 13 is a diagram schematically illustrating an inspection apparatus according to a seventh embodiment of the present invention.
FIG. 14 is a diagram schematically illustrating an inspection apparatus according to an eighth embodiment of the present invention.
FIG. 15 is a diagram for explaining a measurement example of fluorescence.
FIG. 16 is a diagram for explaining another measurement example of fluorescence.
FIG. 17(a) is a diagram illustrating a configuration example related to fluorescence measurement, FIG. 17(b) is a diagram illustrating another configuration example related to fluorescence measurement, and FIG. 17(c) is a diagram illustrating still another configuration example related to fluorescence measurement.

### Description of Embodiments

Embodiments of the present invention will now be described in detail with reference to the accompanying drawings. Note that identical or corresponding elements are denoted by identical reference signs in the description of the drawings, and the redundant descriptions are omitted.

### [First Embodiment]

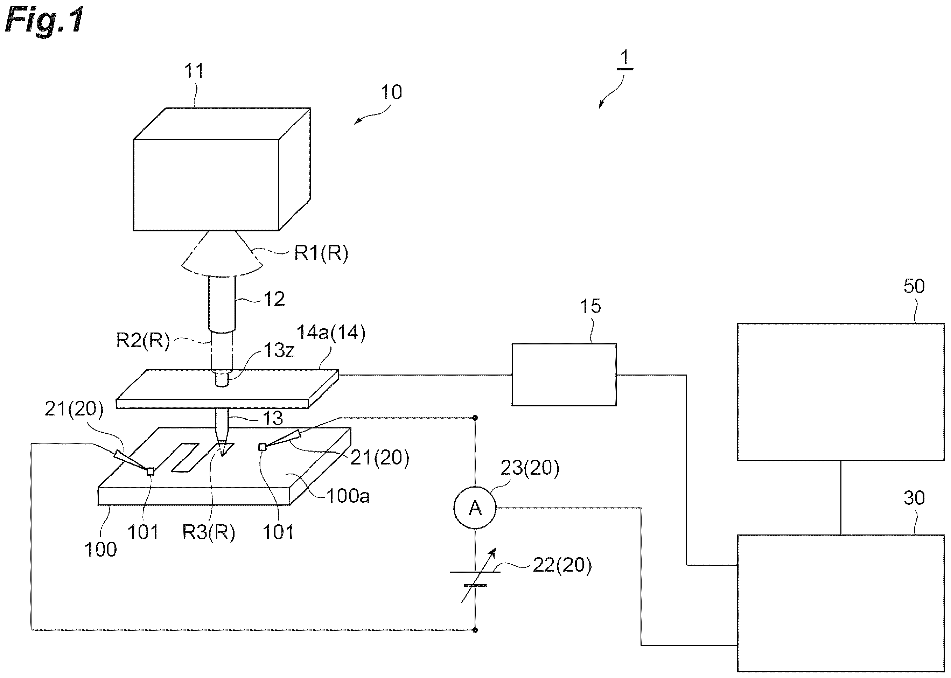

FIG. 1 is a diagram schematically illustrating an inspection apparatus 1 according to a first embodiment of the present invention. The inspection apparatus 1 according to the present embodiment is an apparatus for inspecting a semiconductor device 100, such as identifying a failure part (predetermined position) in the semiconductor device 100 (object) which is a device under test (DUT). More specifically, the inspection apparatus 1 is an apparatus that inspects the semiconductor device 100 to which a test signal is input, and specifies the failure part of the semiconductor device 100 based on an electric signal output from the semiconductor device 100 scanned with X-rays (details will be described later).

In recent years, as a degree of integration of semiconductors increases, a wiring layer becomes thicker, and it becomes difficult to stimulate an inside of a chip for failure analysis. In addition, the number of systems for stacking chips increases, and it becomes increasingly difficult to find an internal failure position. In addition, even though a memory is a single chip, memory cells such as VNAND and BICS are stacked in a vertical direction, and observation and stimulation by light become difficult. In order to solve these problems, the inspection apparatus 1 according to the present embodiment uses the X-rays.

In the present embodiment, the inspection apparatus 1 specifies the failure part of the semiconductor device 100 like an optical beam induced resistance change (OBIRCH) method. In the OBIRCH method, a light beam condensed on the semiconductor device is emitted while a voltage (test signal) is applied to the semiconductor device 100. However, in the method of the present embodiment, the failure part is specified by applying a radiation beam (here, X-ray beam) condensed on the semiconductor device 100, changing a temperature of a specific position of the semiconductor device 100 by the generated heat, and observing a resistance change (electric signal) accompanying the change.

More specifically, in the above method, an electrical characteristic image in which a voltage value or a voltage change value corresponding to the resistance change described above is represented as an electric signal characteristic value in a two-dimensional image is acquired. On the electrical characteristic image, a resistance change (change in voltage) is indicated by a change in luminance. Since a wiring material of the semiconductor device 100 has unique resistance temperature dependency, when there is a defect in a wiring or an insulating layer, a resistance change different from that in a case where there is no defect is exhibited. Such a resistance change is specified from a change in luminance of the electrical characteristic image, the failure part of the semiconductor device 100 can be specified with high accuracy.

In the present embodiment, it has been described that the failure part of the semiconductor device 100 is specified by the above method, but the method of specifying the failure part in the present invention is not limited to the above method. For example, the failure part of the semiconductor device 100 may be specified by a technique such as an optical beam induced current (OBIC) or a dynamic analysis by laser stimulation (DALS). In the case of the method such as OBIC, a photovoltaic current (electric signal) generated by irradiation of a radiation beam (here, X-ray beam) instead of light is detected, an electrical characteristic image obtained by imaging a current value or a current change value of the photovoltaic current as the electric signal characteristic value is acquired, and the failure part is specified based on the electrical characteristic image. In the method such as the DALS, while a pattern signal (test signal) is input by a tester or the like, a result signal (electric signal) output from the semiconductor device 100 that emits a radiation beam (here, X-ray beam) instead of light is acquired, and the failure part is specified based on the result signal.

The semiconductor device 100 is, for example, an individual semiconductor element (discrete), an optoelectronic element, a sensor/actuator, a logic large scale integration (LSI), a memory element, a linear integrated circuit (IC), or the like, or a hybrid device thereof. The individual semiconductor element includes a diode, a power transistor, and the like. The logic LSI includes a transistor having a metal-oxide-semiconductor (MOS) structure, a transistor having a bipolar structure, and the like. In addition, the semiconductor device 100 may be a package including a semiconductor device, a composite substrate, or the like. The semiconductor device 100 may have a substrate and a metal layer formed on the substrate. For example, a silicon substrate is used as the substrate of the semiconductor device 100. The semiconductor device 100 is mounted on, for example, a sample stage (not illustrated).

As illustrated in FIG. 1, the inspection apparatus 1 includes an X-ray beam scanning optical system 10 (radiation beam scanning optical system), a detection unit 20, a controller 30 (analysis unit), and a display unit 50.

The X-ray beam scanning optical system 10 includes an X-ray source 11 (radiation source), a first capillary lens 12, a second capillary lens 13, a shielding member 14, and a drive control unit 15 (control unit). Note that a gamma ray source or the like may be used as the radiation source.

The X-ray source 11 is operated by a power supply (not illustrated) and outputs an X-ray beam R1 toward the semiconductor device 100. Hereinafter, the X-ray beam R1 output from the X-ray source 11, an X-ray beam R2 having passed through the first capillary lens 12, and an X-ray beam R3 passing through the second capillary lens 13 will be described as the X-ray beam R. The X-ray source 11 may be any radiation source as long as the X-ray source is a radiation source capable of outputting the X-rays. At least a part of the X-ray beam R1 output from the X-ray source 11 is guided to the first capillary lens 12.

The first capillary lens 12 is a capillary lens that renders the X-ray beam R1 output from the X-ray source 11 into the X-ray beam R2 which is parallel X-rays (parallel light). The capillary lens is a glass block in which a fine hole is formed substantially in parallel. In a case where a vibration frequency of the X-ray beam is higher than a plasma frequency given by an electron density inside the first capillary lens 12, a refractive index of the X-ray beam is smaller than 1 in glass. As a result, the X-ray beam entering from the hole of the first capillary lens 12 is totally reflected when the X-ray beam is shallowly incident on a glass surface, and is guided to a hole on an opposite side of the incident hole. When one side of the first capillary lens 12 is formed so as to be parallel and an opposite side thereof is condensed, and a condensing point is fixed to a position of the X-ray source 11, a substantially parallel X-ray beam is obtained from an emission side.

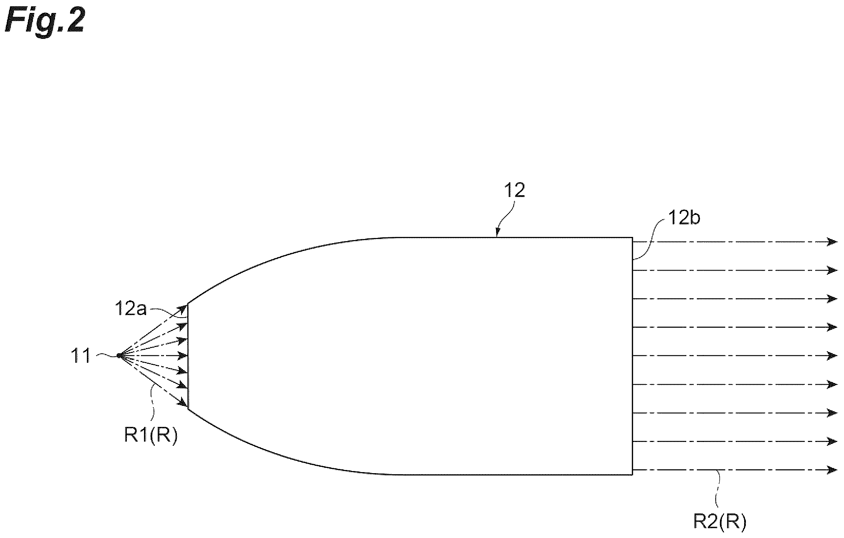

FIG. 2 is a side view illustrating the first capillary lens 12. FIG. 2 illustrates both the X-ray beam R1 incident on the first capillary lens 12 and the X-ray beam R2 emitted from the first capillary lens 12. The first capillary lens 12 has a substantially columnar shape, and a section perpendicular to a central axis is a circle having a center on the central axis. The first capillary lens 12 outputs, as the X-ray beam R2 which is the parallel X-rays (parallel light), the X-ray beam R1 incident on an incident end 12a from a point-shaped X-ray source 11 from an emission end 12b. Thus, a diameter of the first capillary lens 12 gradually increases from the incident end 12a toward the emission end 12b.

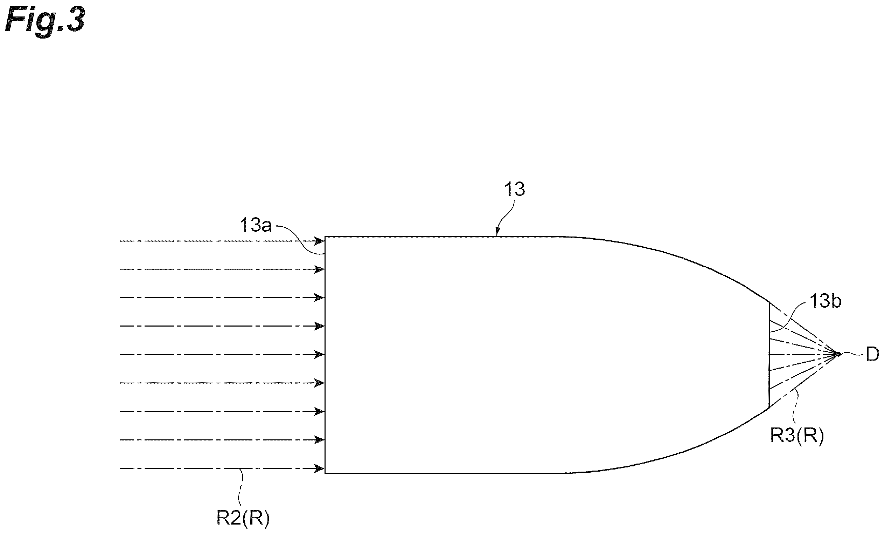

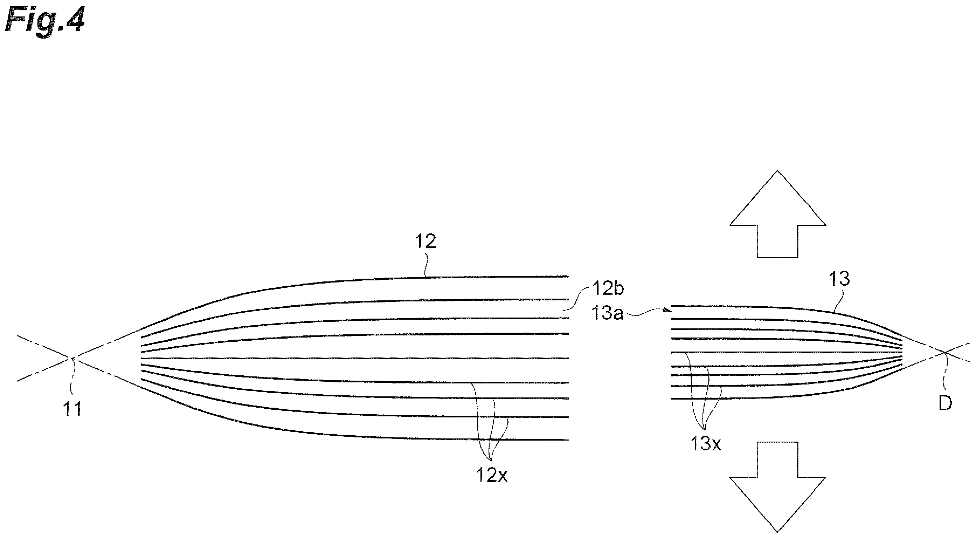

Referring back to FIG. 1, the second capillary lens 13 is a capillary lens that condenses the X-ray beam R2 having passed through the first capillary lens 12 on the semiconductor device 100. FIG. 3 is a side view illustrating the second capillary lens 13. FIG. 3 illustrates both the X-ray beam R2 incident on the second capillary lens 13 and the X-ray beam R3 emitted from the second capillary lens 13. The second capillary lens 13 has a substantially columnar shape, and a section perpendicular to the central axis is a circle having a center on the central axis. The second capillary lens 13 outputs, as a focusing X-ray beam R3 focusing toward a focusing point D of the semiconductor device 100, the X-ray beam R2, which is the parallel X-rays (parallel light) having passed through the first capillary lens 12 and incident on an incident end 13a from an emission end 13b. Thus, a diameter of the second capillary lens 13 gradually decreases from the incident end 13a toward the emission end 13b. A diameter (lens diameter) at the incident end 13a of the second capillary lens 13 is smaller than a diameter (lens diameter) at the emission end 12b of the first capillary lens 12 (see FIG. 4). The X-ray beam R3 emitted from the second capillary lens 13 is perpendicularly incident on a front surface 100a of the semiconductor device 100.

Referring back to FIG. 1, the shielding member 14 is disposed between the X-ray source 11 and the semiconductor device 100, more specifically, between the X-ray source 11 and the emission end 13b of the second capillary lens 13. The shielding member 14 has a downstream shielding unit 14a provided in the second capillary lens 13. The downstream shielding unit 14a is provided around the second capillary lens 13 so as to cover a side surface 13z of the second capillary lens 13. The downstream shielding unit 14a is a plate-shaped member having a substantially rectangular shape in plan view, and is provided with a size, a position, and an angle that can shield the X-ray beam R1 that is not incident on the first capillary lens 12 of the X-ray beam R1 emitted from the X-ray source 11 and the X-ray beam R2 that has passed through the first capillary lens 12 and is not incident on the second capillary lens 13 of the X-ray beam R2. The downstream shielding unit 14a is fixed to the side surface 13z of the second capillary lens 13. The downstream shielding unit 14a functions as a drive unit that moves the fixed second capillary lens 13 by moving in accordance with the control of the drive control unit 15.

The drive control unit 15 controls the downstream shielding unit 14a functioning as the drive unit so as to move the second capillary lens 13 such that the X-ray beam condensed on the semiconductor device 100 is scanned while a state where an optical axis at the emission end 12b of the first capillary lens 12 and an optical axis at the incident end 13a of the second capillary lens 13 are parallel is maintained. Here, two optical axes being parallel means, for example, a case where a difference in angle between the two optical axes is within 0.01 degrees. The drive control unit 15 outputs information indicating a position of the downstream shielding unit 14a, which is a control result, to the controller 30.

FIG. 4 is a diagram for explaining the movement of the second capillary lens 13. The second capillary lens 13 moves as the downstream shielding unit 14a moves in accordance with the control of the drive control unit 15. As illustrated in FIG. 4, the second capillary lens 13 is translated in a direction intersecting optical axes 12x and 13x such that the optical axis 12x at the emission end 12b of the first capillary lens 12 and the optical axis 13x at the incident end 13a of the second capillary lens 13 are constantly parallel to each other.

Here, the drive control unit 15 controls the downstream shielding unit 14a so as to move the second capillary lens 13 within a range in which a light amount of the X-ray beam R2 incident on the incident end 13a of the second capillary lens 13 is constant. The range in which the light amount of the X-ray beam R2 incident on the incident end 13a of the second capillary lens 13 is constant is a range in which the entire region of the incident end 13a falls within a region of the emission end 12b of the first capillary lens 12 as viewed from an optical axis direction.

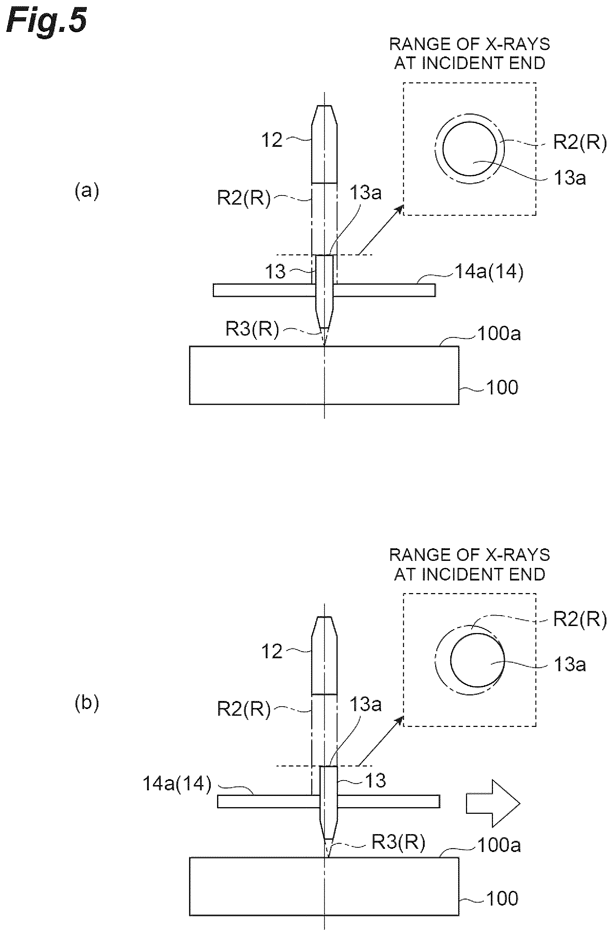

FIG. 5(a) is a diagram for explaining an irradiation range of the X-ray beam R2 in a case where the second capillary lens 13 is positioned at a center position, and FIG. 5(b) is a diagram for explaining an irradiation range of the X-ray beam R2 in a case where the second capillary lens 13 is positioned at an end position. In the example illustrated in FIG. 5(a), the incident end 13a of the second capillary lens 13 is disposed at a center position with respect to the emission end 12b of the first capillary lens 12 as viewed from the optical axis direction. Since the diameter at the incident end 13a of the second capillary lens 13 is smaller than the diameter at the emission end 12b of the first capillary lens 12, only some X-rays (X-rays at a central portion of the X-ray beam R2) included in the X-ray beam R2 are incident on the incident end 13a of the second capillary lens 13 as illustrated in an upper right diagram of FIG. 5(a).

In the example illustrated in FIG. 5(b), the incident end 13a of the second capillary lens 13 is disposed at an end position with respect to the emission end 12b of the first capillary lens 12 as viewed from the optical axis direction. Since the diameter at the incident end 13a of the second capillary lens 13 is smaller than the diameter at the emission end 12b of the first capillary lens 12, as illustrated in an upper right diagram of FIG. 5(b), only a part of the X-ray beam included in the X-ray beam R2 (the X-ray beam at one end portion of the X-ray beam R2) are incident on the incident end 13a of the second capillary lens 13.

Note that, in both the aspects of FIGS. 5(a) and 5(b), since the range is in the range in which the entire region of the incident end 13a of the second capillary lens 13 falls within the region of the emission end 12b of the first capillary lens 12 as viewed from the optical axis direction, the light amount of the X-rays incident on the incident end 13a of the second capillary lens 13 is the same (constant).

Referring back to FIG. 1, the detection unit 20 includes probe pins 21 and 21, a power supply 22, and an ammeter 23. In the detection unit 20, in a situation where the X-ray beam R3 is condensed on the semiconductor device 100, a voltage (test signal) is applied from the power supply 22 to an electrode 101 on the front surface of the semiconductor device 100 through the probe pins 21. A change in current is acquired in the ammeter 23 via the electrode 101 and the probe pins 21. Such a change in current indicates a resistance change (electric signal) accompanying a temperature change due to generated heat. The ammeter 23 outputs the measured current value to the controller 30.

The controller 30 includes a computer. The controller 30 inspects the semiconductor device 100 based on the current value measured by the ammeter 23, which is the electric signal output from the semiconductor device 100 scanned with the X-ray beam R3. The controller 30 acquires the current value measured by the ammeter 23, performs signal processing to generate the electrical characteristic image, and displays the electrical characteristic image on the display unit 50.

The controller 30 continuously acquires the information indicating the position of the downstream shielding unit 14a when the X-ray beam condensed on the semiconductor device 100 is scanned, that is, an X-ray scanning position from the drive control unit 15. Thus, the controller 30 can appropriately specify which position in the semiconductor device 100 is the failure part by monitoring the current value acquired from the ammeter 23 and detecting a change in resistance value.

Next, actions and effects of the X-ray beam scanning optical system 10 and the inspection apparatus 1 according to the present embodiment will be described.

The X-ray beam scanning optical system 10 according to the present embodiment includes the X-ray source 11 that outputs the X-ray beam R1 toward the semiconductor device 100, the first capillary lens 12 that renders the X-ray beam R1 output from the X-ray source 11 into the X-ray beam R2 that is the parallel X-rays, the second capillary lens 13 that condenses the X-ray beam R2 having passed through the first capillary lens 12 on the semiconductor device 100, and the shielding member 14 disposed between the X-ray source 11 and the semiconductor device 100, more specifically, the emission end 13b of the second capillary lens 13. Further, the inspection apparatus 1 includes a drive unit (here, shielding member 14) that moves the second capillary lens 13, and the drive control unit 15 that controls the shielding member 14 so as to move the second capillary lens 13 such that the X-ray beam condensed on the semiconductor device 100 is scanned while a state where the optical axis at the emission end 12b of the first capillary lens 12 and the optical axis at the incident end 13a of the second capillary lens 13 are parallel is maintained.

In the X-ray beam scanning optical system 10 according to the present embodiment, the X-ray beam R2 rendered into the parallel X-ray by the first capillary lens 12 is condensed on the semiconductor device 100 by the second capillary lens 13. As described above, the beam is once rendered into the parallel X-ray beam R2 and then condensed on the semiconductor device 100 by the second capillary lens 13, and thus, condensing accuracy can be enhanced. In the X-ray beam scanning optical system 10, the second capillary lens 13 is moved while a parallel relationship between the optical axes of the first capillary lens 12 and the second capillary lens 13 is maintained, and thus, the X-ray beam R3 is scanned in the semiconductor device 100. As described above, when the second capillary lens 13 moves, the parallel relationship between the optical axes of the first capillary lens 12 and the second capillary lens 13 is maintained, and thus, the X-ray beam R3 can be scanned while the condensing accuracy is maintained. As described above, the X-ray beam scanning optical system 10 according to the present embodiment can appropriately scan the semiconductor device 100 with the X-ray beam R3 by moving the second capillary lens 13 without moving the X-ray source 11 and the semiconductor device 100.

The first capillary lens 12 and the second capillary lens 13 have a substantially columnar shape, and the lens diameter at the incident end 13a of the second capillary lens 13 may be smaller than the lens diameter at the emission end 12b of the first capillary lens 12. According to such a configuration, a range in which the X-ray beam R2 is emitted from the first capillary lens 12 can be widened, and a range in which the X-ray beam R3 can be scanned by the movement of the second capillary lens 13 can be widened. As a result, the semiconductor device 100 can be more appropriately scanned with the X-ray beam R3.

The shielding member 14 may have the downstream shielding unit 14a provided in the second capillary lens 13. According to such a configuration, the X-ray beam R2 emitted from the first capillary lens 12 and not incident on the second capillary lens 13 can be appropriately shielded.

The downstream shielding unit 14a may be provided so as to cover the side surface 13z of the second capillary lens 13. According to such a configuration, the X-ray beam R2 can be appropriately shielded on the side surface 13z of the second capillary lens 13.

The downstream shielding unit 14a may function as the drive unit that moves the second capillary lens 13. According to such a configuration, the shielding unit can also be used as the drive unit, and an apparatus configuration can be simplified as compared with a case where the shielding unit is provided separately.

The drive control unit 15 may control the downstream shielding unit 14a so as to move the second capillary lens 13 within a range in which the light amount of the X-ray beam R2 incident on the incident end 13a of the second capillary lens 13 is constant. According to such a configuration, a variation in light amount of radiation at the time of scanning is suppressed, and the semiconductor device 100 can be more appropriately scanned with the X-ray beam R3.

The inspection apparatus 1 is an inspection apparatus that inspects the semiconductor device 100 to which the voltage (test signal) is input, and includes the above-described X-ray beam scanning optical system 10 and the controller 30 that inspects the semiconductor device 100 based on the electric signal output from the semiconductor device 100 scanned with the X-ray. According to such an inspection apparatus 1, the above-described X-ray beam scanning optical system 10 appropriately scans the semiconductor device 100 with the X-ray beam without moving the X-ray source 11 and the semiconductor device 100, and the semiconductor device 100 can be inspected with high accuracy.

### [Second Embodiment]

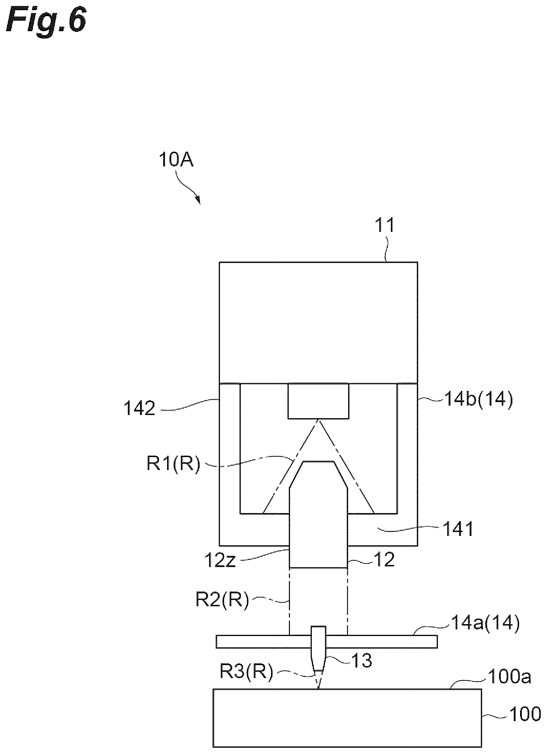

Next, an X-ray beam scanning optical system 10A according to a second embodiment of the present invention will be described with reference to FIG. 6. FIG. 6 is a diagram schematically illustrating the X-ray beam scanning optical system 10A according to the second embodiment. In the second embodiment, differences from the first embodiment will be mainly described, and common description will be omitted.

As illustrated in FIG. 6, the X-ray beam scanning optical system 10A according to the second embodiment further includes an upstream shielding unit 14b as the configuration of the shielding member 14 in addition to the configuration of the above-described X-ray beam scanning optical system 10. The upstream shielding unit 14b is a shielding member provided in the first capillary lens 12. The upstream shielding unit 14b is provided in the first capillary lens 12 and is provided so as to surround at least an emission portion of the X-ray source 11. As viewed from the optical axis direction, the upstream shielding unit 14b may be provided so as to surround a target electrode of the semiconductor device 100.

As illustrated in FIG. 6, the upstream shielding unit 14b is formed in, for example, a box shape (specifically, a box shape having no upper surface), and includes a bottom surface portion 141 and four wall portions 142 erected from an edge portion of the bottom surface portion 141 and extending to the X-ray source 11. The bottom surface portion 141 is provided so as to surround the side surface 12z of the first capillary lens 12.

As described above, the shielding member 14 includes the upstream shielding unit 14b provided in the first capillary lens 12, and thus, the X-ray beam R1 output from the X-ray source 11 and not incident on the first capillary lens 12 can be appropriately shielded.

In addition, the upstream shielding unit 14b is provided so as to surround the X-ray source 11, and thus, the X-ray beam R1 output from the X-ray source 11 and not incident on the first capillary lens 12 can be more reliably shielded.

In addition, in the X-ray beam scanning optical system 10A, the shielding member 14 includes both the downstream shielding unit 14a provided in the second capillary lens 13 and the upstream shielding unit 14b provided in the first capillary lens 12. According to such a configuration, both the X-ray beam R1 output from the X-ray source 11 and the X-ray beam R2 emitted from the first capillary lens 12 can be appropriately shielded.

### [Third Embodiment]

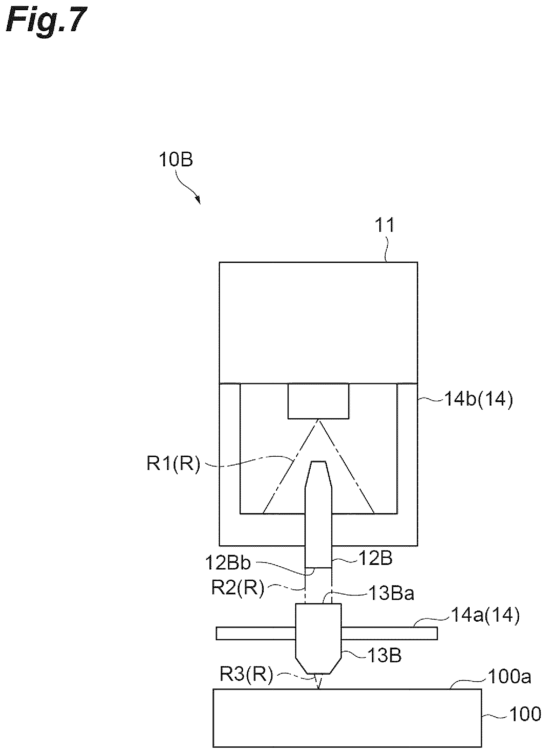

Next, an X-ray beam scanning optical system 10B according to a third embodiment of the present invention will be described with reference to FIGS. 7 to 9. FIG. 7 is a diagram schematically illustrating an X-ray beam scanning optical system 10B according to the third embodiment. In the third embodiment, differences from the first embodiment and the second embodiment will be mainly described, and common description will be omitted.

As illustrated in FIG. 7, the X-ray beam scanning optical system 10B according to the third embodiment includes a first capillary lens 12B and a second capillary lens 13B instead of the first capillary lens 12 and the second capillary lens 13 (see FIG. 1) of the above-described X-ray beam scanning optical system 10. The first capillary lens 12B renders the X-ray beam R1 output from the X-ray source 11 into the parallel X-rays. The second capillary lens 13B condenses the X-ray beam R2 having passed through the first capillary lens 12B on the semiconductor device 100.

Each of the first capillary lens 12B and the second capillary lens 13B has a substantially columnar shape. A lens diameter at an incident end 13Ba of the second capillary lens 13B is larger than a lens diameter at an emission end 12Bb of the first capillary lens 12B. As described above, in the X-ray beam scanning optical system 10B according to the third embodiment, a magnitude relationship between the lens diameters of the first capillary lens and the second capillary lens is opposite to that of the X-ray beam scanning optical system 10 according to the first embodiment.

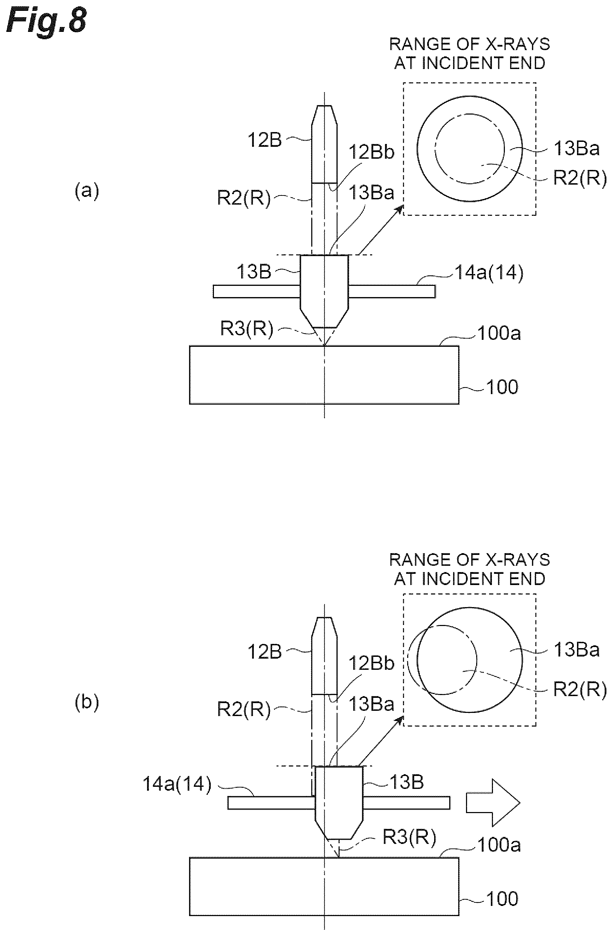

FIG. 8(a) is a diagram for explaining an X-ray irradiation range in a case where the second capillary lens 13B is positioned at a center position, and FIG. 8 (b) is a diagram for explaining an X-ray irradiation range in a case where the second capillary lens 13B is positioned at the end position. In the example illustrated in FIG. 8(a), the incident end 13Ba of the second capillary lens 13B is disposed at a center position with respect to the emission end 12Bb of the first capillary lens 12B as viewed from the optical axis direction. Since a diameter at the incident end 13Ba of the second capillary lens 13B is larger than a diameter at the emission end 12Bb of the first capillary lens 12B, all the X-rays included in the X-ray beam R2 are incident on the incident end 13Ba of the second capillary lens 13B as illustrated in the upper right diagram of FIG. 5(a).

In the example illustrated in FIG. 8(b), the incident end 13Ba of the second capillary lens 13B is disposed at an end position with respect to the emission end 12Bb of the first capillary lens 12 as viewed from the optical axis direction. Although the diameter at the incident end 13Ba of the second capillary lens 13B is larger than the diameter at the emission end 12Bb of the first capillary lens 12B, as illustrated in the upper right diagram of FIG. 8 (b), in a case where the position of the incident end 13Ba of the second capillary lens 13B is greatly shifted from a center, some X-ray beams included in the X-ray beam R2 are not incident on the incident end 13Ba. As described above, since there is a case where a part of the X-ray beam R2 is not incident on the incident end 13Ba depending on the position of the second capillary lens 13B, even in a case where the diameter at the incident end 13Ba of the second capillary lens 13B is larger than the diameter at the emission end 12Bb of the first capillary lens 12B, the downstream shielding unit 14a is provided for safety as illustrated in FIG. 8(b) and the like.

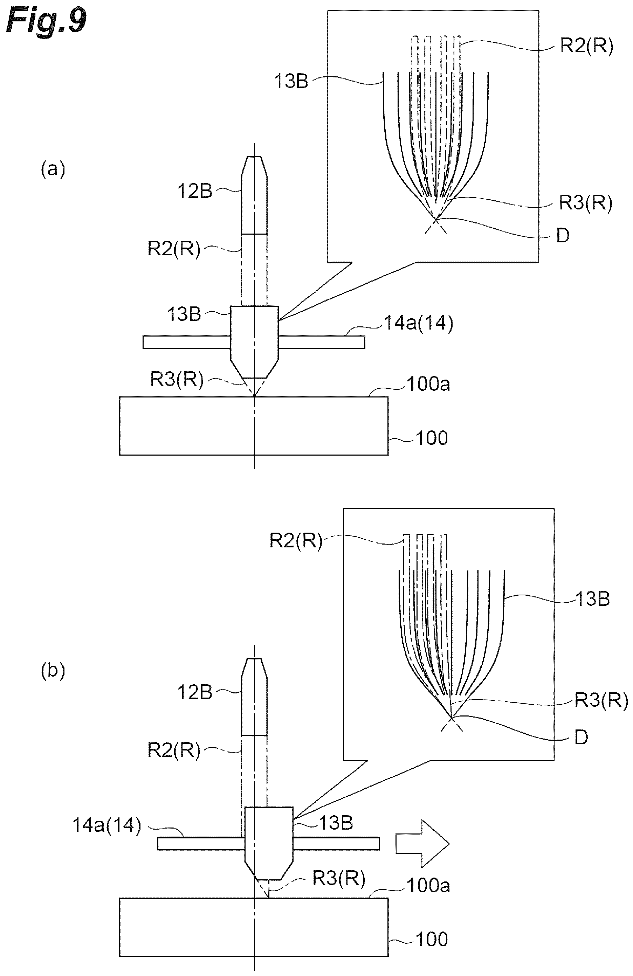

FIG. 9(a) is a diagram for explaining paths of the X-ray beams R2 and R3 in a case where the second capillary lens 13B is positioned at the center position (see FIG. 8(a)), and FIG. 9(b) is a diagram for explaining the paths of the X-ray beams R2 and R3 in a case where the second capillary lens 13B is positioned at an end position (see FIG. 8(b)). As illustrated in FIG. 9(a), in a case where a usage ratio of the central portion of the second capillary lens 13B is large, a loss of a high energy component of the X-ray beam R2 is small. On the other hand, as illustrated in FIG. 9(b), in a case where the usage ratio of an end portion of the second capillary lens 13B is large, the high energy component of the X-ray beam R2 is likely to be lost in a largely bending path.

As described above, in the X-ray beam scanning optical system 10B according to the third embodiment, the lens diameter at the incident end 13Ba of the second capillary lens 13B is larger than the lens diameter at the emission end 12Bb of the first capillary lens 12B. According to such a configuration, utilization efficiency of the X-ray beam R2 emitted from the first capillary lens 12B can be increased, and the semiconductor device 100 can be scanned with the X-ray beam R3. That is, the lens diameter at the incident end 13Ba of the second capillary lens 13B is large, and thus, the X-ray beam R2 emitted from the first capillary lens 12B is easily incident on the incident end 13Ba of the second capillary lens 13B. As a result, the utilization efficiency of the X-ray beam R2 can be increased.

### [Fourth Embodiment]

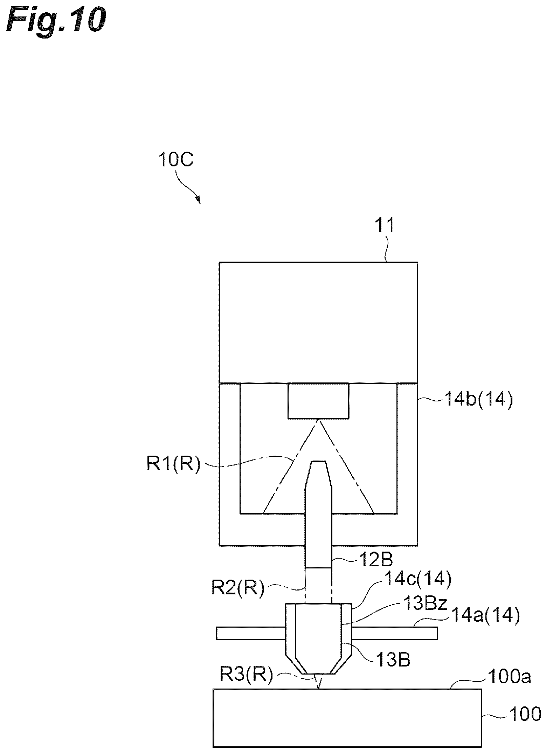

Next, an X-ray beam scanning optical system 10C according to a fourth embodiment of the present invention will be described with reference to FIG. 10. FIG. 10 is a diagram schematically illustrating the X-ray beam scanning optical system 10C according to the fourth embodiment. In the fourth embodiment, differences from the third embodiment will be mainly described, and common description will be omitted.

As illustrated in FIG. 10, the X-ray beam scanning optical system 10C according to the fourth embodiment further includes a capillary lens shielding unit 14c as the configuration of the shielding member 14 in addition to the configuration of the above-described X-ray beam scanning optical system 10B (see FIG. 7). The capillary lens shielding unit 14c is a shielding member that completely covers the entire region of a side surface 13Bz of the second capillary lens 13B. For example, the capillary lens shielding unit 14c may cover the entire region excluding the incident end 13Ba and the emission end 13Bb of the second capillary lens 13B.

### [Fifth Embodiment]

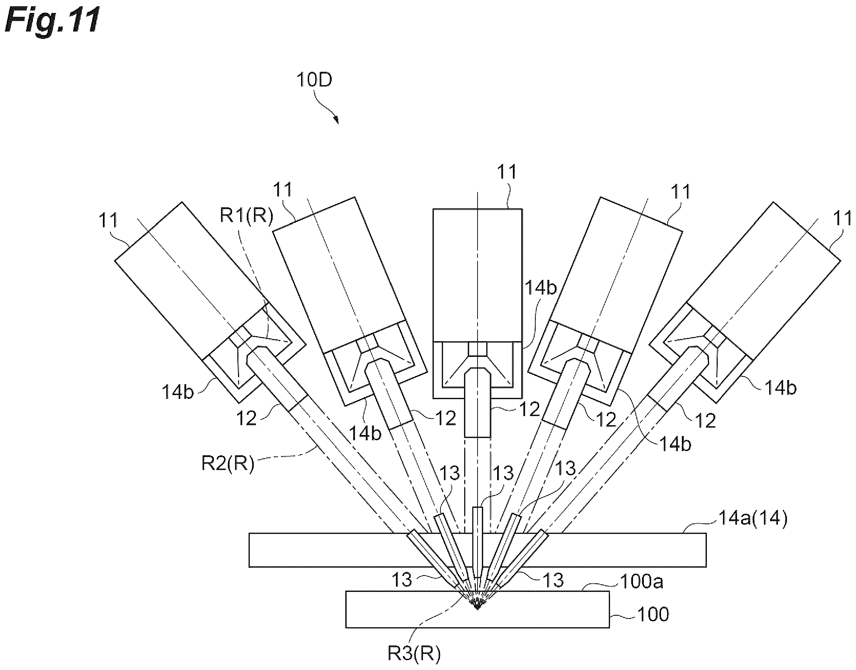

Next, an X-ray beam scanning optical system 10D according to a fifth embodiment of the present invention will be described with reference to FIG. 11. FIG. 11 is a diagram schematically illustrating the X-ray beam scanning optical system 10D according to the fifth embodiment. In the fifth embodiment, differences from the second embodiment will be mainly described, and common description will be omitted.

As illustrated in FIG. 11, the X-ray beam scanning optical system 10D according to the fifth embodiment includes a plurality of sets of configurations such as the X-ray source 11 of the above-described X-ray beam scanning optical system 10A (see FIG. 6). Specifically, the X-ray beam scanning optical system 10D includes a plurality of sets of configurations other than the downstream shielding unit 14a among the configurations of the X-ray beam scanning optical system 10A, and includes only one downstream shielding unit 14a in common.

As illustrated in FIG. 11, the X-ray beam scanning optical system 10D includes a plurality of sets (five sets) of condensing sets each including one X-ray source 11, one first capillary lens 12, one second capillary lens 13, and one upstream shielding unit 14b. The X-ray beam scanning optical system 10D includes one downstream shielding unit 14a as a common downstream shielding unit of the five condensing sets. The downstream shielding unit 14a moves, and thus, the X-rays condensed on the semiconductor device 100 are scanned. As a result, the X-rays from each condensing set are condensed at one point.

In order to stimulate one point in the semiconductor device 100 with the X-rays, it is preferable to emit the X-rays from a plurality of directions. In this respect, as described above, the plurality of condensing sets are provided, and the X-rays can be emitted from the plurality of directions. As a result, one point in the semiconductor device 100 can be effectively stimulated.

### [Sixth Embodiment]

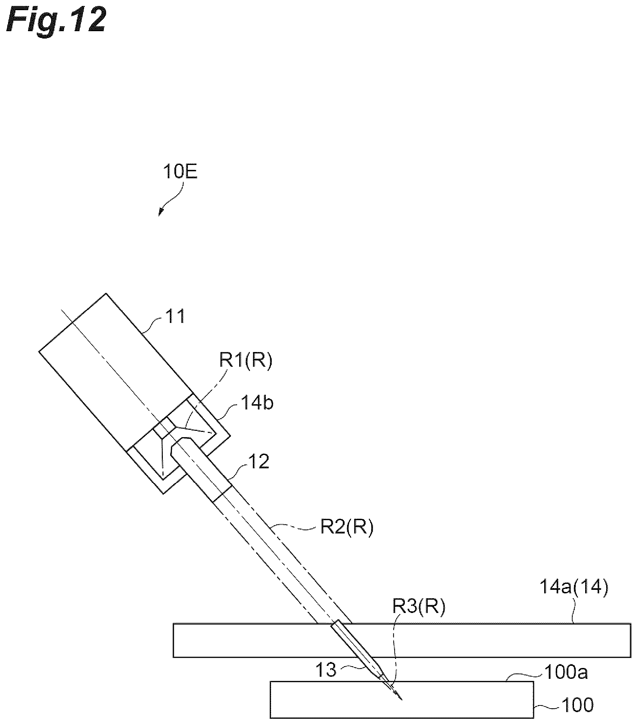

Next, an X-ray beam scanning optical system 10E according to a sixth embodiment of the present invention will be described with reference to FIG. 12. FIG. 12 is a diagram schematically illustrating the X-ray beam scanning optical system 10E according to the sixth embodiment. In the sixth embodiment, differences from the second embodiment will be mainly described, and common description will be omitted.

As illustrated in FIG. 12, the X-ray beam scanning optical system 10E of the sixth embodiment has the same configuration as the above-described X-ray beam scanning optical system 10A (see FIG. 6), but an incident angle of the X-ray beam R3 with respect to the front surface 100a of the semiconductor device 100 is different from an incident angle in the X-ray beam scanning optical system 10A. That is, in the X-ray beam scanning optical system 10E, the X-ray beam R3 emitted from the second capillary lens 13 is obliquely incident on the front surface 100a of the semiconductor device 100 (at an angle other than perpendicular). As described above, even in the configuration in which the X-ray beam R3 is incident from an angle other than a perpendicular angle, the semiconductor device 100 can be appropriately scanned with the X-ray.

### [Seventh Embodiment]

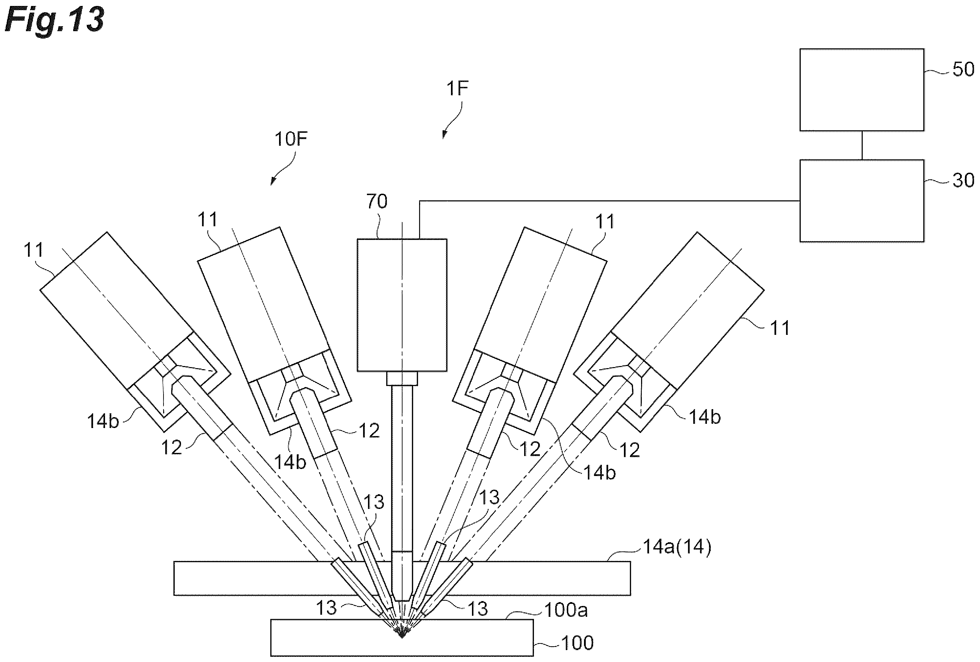

Next, an inspection apparatus 1F according to a seventh embodiment of the present invention and an X-ray beam scanning optical system 10F included in the inspection apparatus 1 will be described with reference to FIG. 13. FIG. 13 is a diagram schematically illustrating the inspection apparatus 1F according to the seventh embodiment. In the seventh embodiment, differences from the fifth embodiment will be mainly described, and common description will be omitted.

As illustrated in FIG. 13, the X-ray beam scanning optical system 10F included in the inspection apparatus 1F according to the seventh embodiment includes a plurality of sets of condensing sets including the configuration of the X-ray source 11 and the like similarly to the above-described X-ray beam scanning optical system 10D (see FIG. 11). In the X-ray beam scanning optical system 10D, the five sets of condensing sets are provided, but in the X-ray beam scanning optical system 10F, one condensing set, specifically, a condensing set facing the front surface 100a of the semiconductor device 100 is replaced by an imaging unit 70. That is, the X-ray beam scanning optical system 10F includes four condensing sets in which the X-ray beam R3 is obliquely incident on the front surface 100a, and the imaging unit 70 facing the front surface 100a. The imaging unit 70 is a visible camera for observation that captures the front surface of the semiconductor device 100, and outputs a captured image to the controller 30.

The controller 30 included in the inspection apparatus 1F acquires the current value measured by the ammeter 23 (see FIG. 1) and performs signal processing to generate the electrical characteristic image. In addition, the controller 30 also acquires the captured image from the imaging unit 70. The controller 30 displays a combined image obtained by combining the electrical characteristic image and the captured image on the display unit 50.

As described above, the combined image obtained by combining the electrical characteristic image and the captured image captured by the imaging unit 70 is displayed on the display unit 50, and thus, the failure part of the semiconductor device 100 can be specified more easily and with high accuracy.

### [Eighth Embodiment]

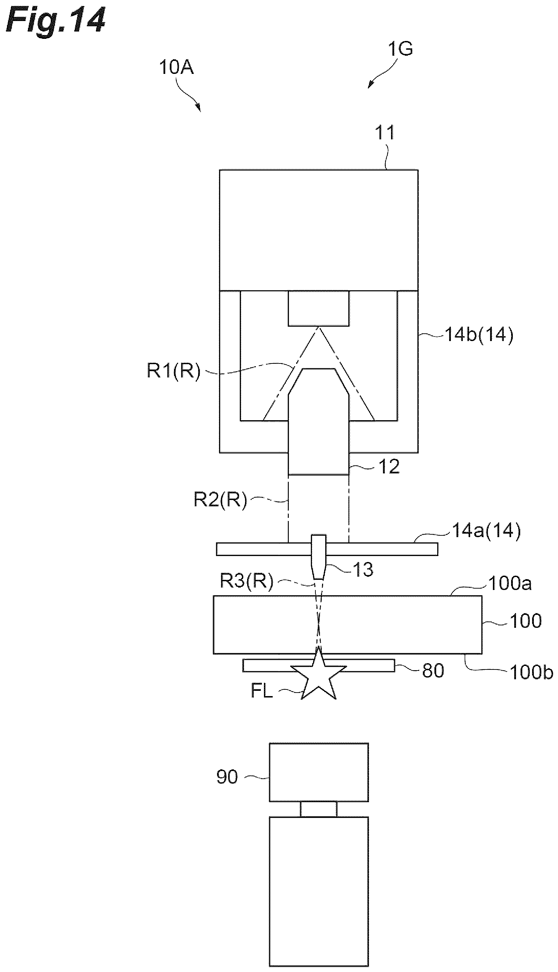

Next, an inspection apparatus 1G according to an eighth embodiment of the present invention will be described with reference to FIG. 14. FIG. 14 is a diagram schematically illustrating the inspection apparatus 1G according to the eighth embodiment. In the eighth embodiment, differences from the second embodiment will be mainly described, and common description will be omitted.

As illustrated in FIG. 14, the inspection apparatus 1G according to the eighth embodiment further includes a scintillator 80 that absorbs the X-ray beam R3 and emits fluorescence FL, and an imaging unit 90, in addition to the configuration of the above-described X-ray beam scanning optical system 10A (see FIG. 6). The scintillator 80 and the imaging unit 90 are disposed on an opposite side of the X-ray beam scanning optical system 10A with respect to the semiconductor device 100 (a back surface 100b side of the semiconductor device 100).

The scintillator 80 is disposed on the back surface 100b on an opposite side of the front surface 100a of the semiconductor device 100. The scintillator 80 is disposed, for example, in an opening portion (not illustrated) of a wafer chuck. The scintillator 80 absorbs the scanned X-ray beam R3 and emits the fluorescence FL.

The imaging unit 90 is a camera with a lens disposed on an opposite side of the semiconductor device 100 with respect to the scintillator 80. The imaging unit 90 captures the fluorescence FL emitted by the scintillator 80 to capture a transmission image by the scanned X-ray beam R3. The imaging unit 90 may output the captured image (transmission image) to the controller 30. In this case, it is possible to specify the failure part of the semiconductor device 100 in consideration of the transmission image.

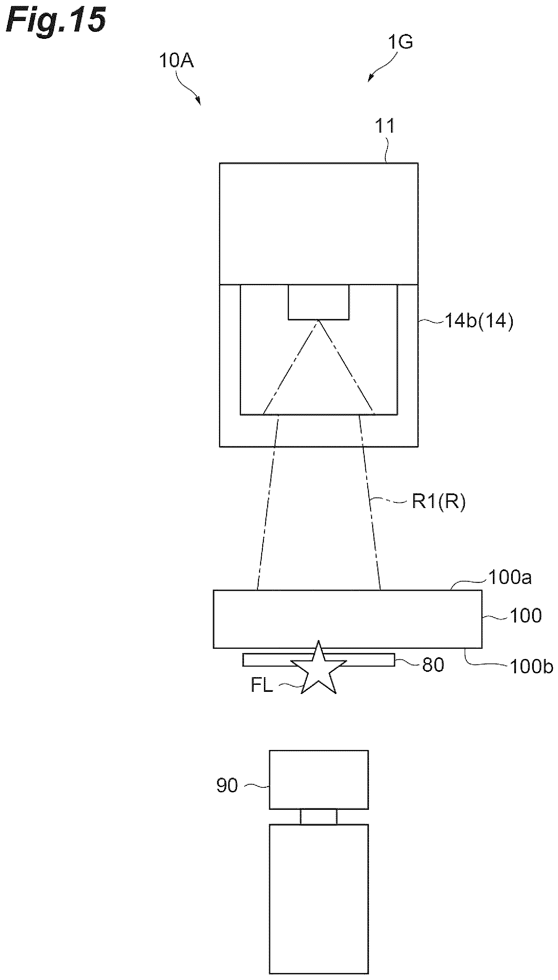

Note that the method for measuring the fluorescence using the scintillator 80 and the imaging unit 90 is not limited to the aspect illustrated in FIG. 14. FIG. 15 is a diagram for explaining a measurement example of the fluorescence. As illustrated in FIG. 15, the configurations (first capillary lens 12, second capillary lens 13, and downstream shielding unit 14a) included in the X-ray beam scanning optical system 10A are retracted from an optical path, and the X-rays spread and emitted from the X-ray source 11 without passing through the capillary lens are emitted to a wide area of the semiconductor device 100. As a result, the fluorescence FL emitted from the scintillator 80 may be captured by the imaging unit 90, and the structure of the semiconductor device 100 may be detected in the area.

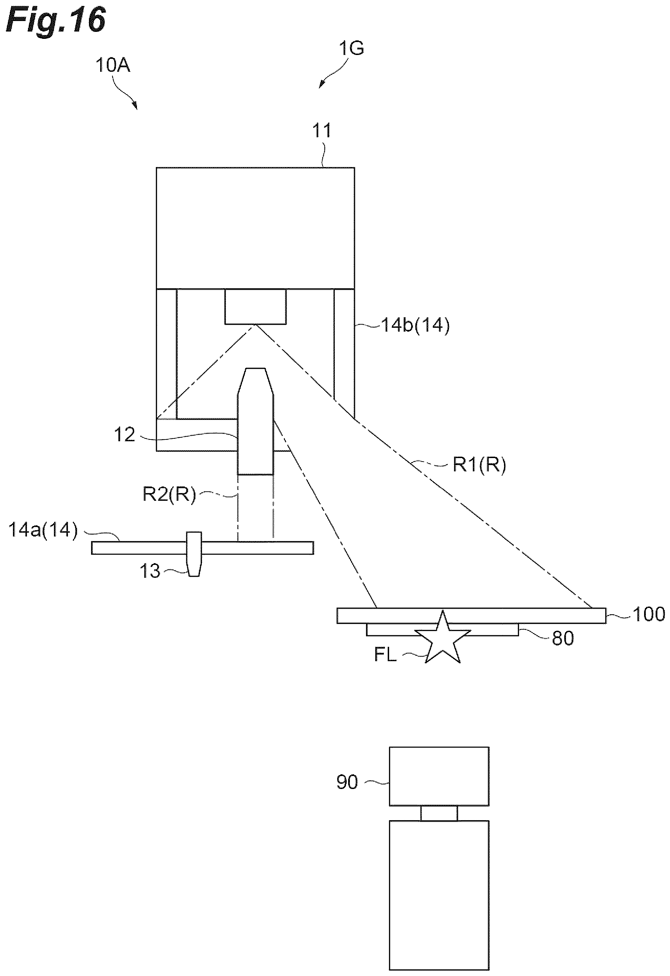

FIG. 16 is a diagram for explaining another measurement example of the fluorescence. In the example illustrated in FIG. 16, first, while the first capillary lens 12 is fixed, the second capillary lens 13 and the downstream shielding unit 14a are retracted from the optical path. In this state, the X-ray beam R2 having passed through the first capillary lens 12 is shielded by the downstream shielding unit 14a. A part of the upstream shielding unit 14b is opened, and the semiconductor device 100 and the scintillator 80 are disposed on an optical path extending downward from the opened portion. In this case, a wide area of the semiconductor device 100 is irradiated with the X-ray beam R1 spread and emitted from the X-ray source 11 without passing through the capillary lens, and thus, the fluorescence FL emitted from the scintillator 80 is captured by the imaging unit 90. As a result, the structure of the semiconductor device 100 is detected in the area.

Note that, in the example illustrated in FIG. 16, positions of the semiconductor device 100, the scintillator 80, and the imaging unit 90 are moved, but the capturing of the fluorescence FL described above may be performed without the moving thereof.

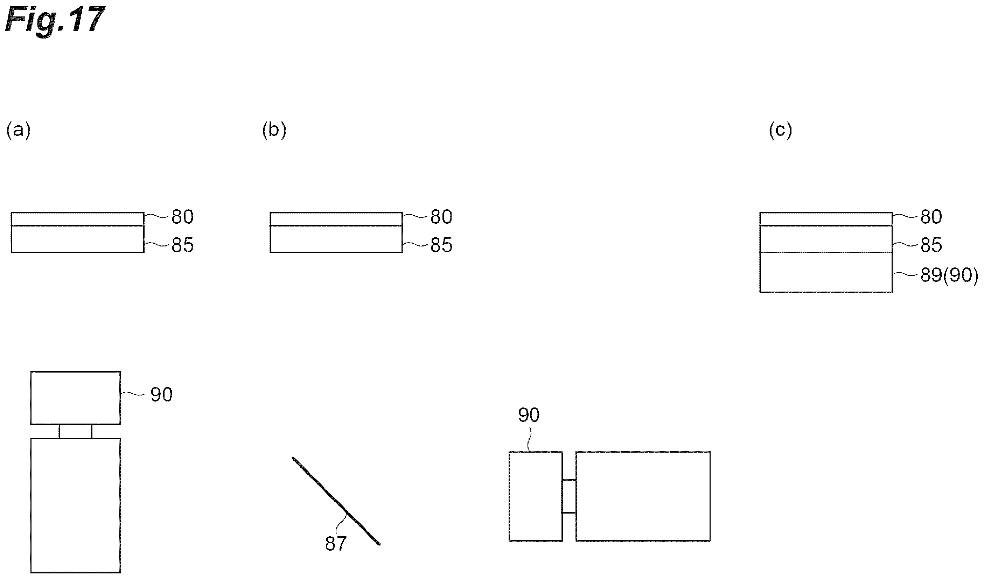

FIG. 17(a) is a diagram illustrating a configuration example related to the fluorescence measurement, FIG. 17(b) is a diagram illustrating another configuration example related to the fluorescence measurement, and FIG. 17(c) is a diagram illustrating still another configuration example related to the fluorescence measurement. As illustrated in FIG. 17(a), in order to prevent exposure of the imaging unit 90 to the X-rays, a fiber optic plate (FOP) 85 may be provided on a surface of the scintillator 80 on the imaging unit 90 side. In addition, as illustrated in FIG. 17(b), in order to prevent exposure of the imaging unit 90 to the X-rays, a mirror 87 may be disposed between the scintillator 80 and the imaging unit 90, and only the fluorescence FL may be guided to the imaging unit 90. In addition, as illustrated in FIG. 17(c), a detector 89 such as a CCD or a CMOS that detects light changed by the scintillator 80 may be used as the imaging unit 90. In this case, the FOP 85 may be lens-coupled to the detector 89 and may be directly coupled to the detector 89.

### Reference Signs List

1, 1F, 1G inspection apparatus
10, 10A, 10B, 10C, 10D, 10E, 10F X-ray beam scanning optical system (radiation beam scanning optical system)
11 X-ray source (radiation source)
12, 12B first capillary lens
12b, 12Bb emission end
12x, 13x optical axis
12z side surface
13, 13B second capillary lens
13a, 13Ba incident end
13z, 13Bz side surface
14 shielding member
14a downstream shielding unit (drive unit)
14b upstream side shielding unit
15 drive control unit (control unit)
30 controller (analysis unit)
100 semiconductor device

## Claims

1. A radiation beam scanning optical system comprising:
a radiation source configured to output a radiation beam toward an object;
a first capillary lens configured to render the radiation beam output from the radiation source into parallel light;
a second capillary lens configured to condense the radiation beam having passed through the first capillary lens on the object;
a shielding member disposed between the radiation source and the object;
a drive unit configured to move the second capillary lens; and
a control unit configured to control the drive unit to move the second capillary lens such that the radiation beam condensed on the object is scanned while a state where an optical axis at an emission end of the first capillary lens and an optical axis at an incident end of the second capillary lens are parallel is maintained.

2. The radiation beam scanning optical system according to claim 1, wherein
the first capillary lens and the second capillary lens have a substantially columnar shape, and
a lens diameter at the incident end of the second capillary lens is smaller than a lens diameter at the emission end of the first capillary lens.

3. The radiation beam scanning optical system according to claim 1, wherein
the first capillary lens and the second capillary lens have a substantially columnar shape, and
a lens diameter at the incident end of the second capillary lens is larger than a lens diameter at the emission end of the first capillary lens.

4. The radiation beam scanning optical system according to claim 2 or 3, wherein the shielding member is disposed between the radiation source and an emission end of the second capillary lens.

5. The radiation beam scanning optical system according to claim 2 or 3, wherein the shielding member includes a downstream shielding unit provided in the second capillary lens.

6. The radiation beam scanning optical system according to claim 5, wherein the downstream shielding unit is provided so as to cover a side surface of the second capillary lens.

7. The radiation beam scanning optical system according to claim 6, wherein the downstream shielding unit functions as the drive unit.

8. The radiation beam scanning optical system according to claim 2 or 3, wherein the shielding member includes an upstream shielding unit provided in the first capillary lens.

9. The radiation beam scanning optical system according to claim 8, wherein the upstream shielding unit is provided so as to surround the radiation source.

10. The radiation beam scanning optical system according to claim 2 or 3, wherein the shielding member includes a downstream shielding unit provided in the second capillary lens and an upstream shielding unit provided in the first capillary lens.

11. The radiation beam scanning optical system according to claim 2 or 3, wherein the control unit is configured to control the drive unit to move the second capillary lens within a range in which a light amount of the radiation beam incident on the incident end of the second capillary lens is constant.

12. The radiation beam scanning optical system according to claim 1, comprising a plurality of sets of condensing sets each including one radiation source, one first capillary lens, and one second capillary lens.

13. An inspection apparatus that inspects a semiconductor device to which a test signal is input, the inspection apparatus comprising:
the radiation beam scanning optical system according to any one of claims 1 to 12 in which the semiconductor device is scanned with a radiation beam with the semiconductor device as the object; and
an analysis unit configured to inspect the semiconductor device based on an electric signal output from the semiconductor device scanned with the radiation beam.
